# EUROPÄISCHE PATENTSCHRIFT

(11) **EP 4 052 548 B1**
(45) Veröffentlichungstag und Bekanntmachung des Hinweises auf die Patenterteilung: **24.07.2024**
(21) Anmeldenummer: 20803085.8
(22) Anmeldetag: 19.10.2020
(51) Int. Cl.: H05K 5/00, H05K 5/02

(54) **GEHÄUSE FÜR ELEKTRONISCHE BAUTEILE**
HOUSING FOR ELECTRONIC COMPONENTS
BOÎTIER POUR COMPOSANTS ÉLECTRONIQUES

(30) Priorität: 31.10.2019 DE 102019129448
(43) Veröffentlichungstag der Anmeldung: 07.09.2022
(73) Patentinhaber: HARTING Electric Stiftung & Co. KG, 32339 Espelkamp (DE)
(72) Erfinder: LOSKE, Felix, 32339 Espelkamp (DE); FRIESEN, Markus, 32339 Espelkamp (DE); VOLLMER, Christian, 32339 Espelkamp (DE); GRÄFF, Uwe, 32339 Espelkamp (DE)
(86) Internationale Anmeldenummer: PCT/DE2020/100899
(87) Internationale Veröffentlichungsnummer: WO 2021/083455

(56) Entgegenhaltungen:
- DE-A1- 4 432 509

## Beschreibung

Die Erfindung geht aus von einem System, welches elektronische Bauteile umfasst, nach der Gattung des unabhängigen Anspruchs 1.

Derartige Systeme sollen insbesondere den darin eingebetteten, elektronischen Komponenten Schutz bieten. Die Systeme werden insbesondere im industriellen Umfeld eingesetzt.

### Stand der Technik

DE 296 18 489 U1 zeigt eine Vorrichtung zur Umsetzung und/oder Übertragung von optischen und/oder elektrischen Signalen mit einem Anschlussmodul zum Anschliessen an ein optisches und/oder elektrisches Leitungsnetz und mit einem mit dem Anschlussmodul in verschiedenen Winkelstellungen kuppelbaren Anwendungsmodul, wobei das Anschlussmodul ein Gehäuse mit einer im wesentlichen quadratischen Grundfläche aufweist, wobei das Gehäuse auf der dem Anwendungsmodul zugewandten Oberseite mit einer allseitig im Wesentlichen gleichmässig über das Gehäuse vorstehenden Montageplatte mit symmetrisch angeordneten Befestigungselementen zum Befestigen des Anschlussmoduls versehen ist, wobei die Montageplatte als Leiterplatte mit Stiftleisten zum Aufstecken des Anwendungsmoduls ausgebildet ist.

Die DE 44 32 509 A1 zeigt ein Elektro-Installationsgerät zur Montage in Kabelkanälen, Unterflurgehäusen, Verteilerschränken, Schaltschränken oder dergleichen Aufnahmegehäusen mit inneren Bodenhalteprofilen.

Die EP 2 783 423 B1 zeigt ein Gehäuse in welches eine elektronische Leiterplatte eingebettet ist, wobei die elektronische Leiterplatte mehrere elektrische Anschlüsse umfasst. Die elektrischen Anschlüsse sind über eine Steckverbinderbuchse im Gehäuse erreichbar.

In diesem Fall müssen die elektrischen Anschlüsse der Leiterplatte geometrisch mit der Steckverbinderbuchse des Gehäuses korrelieren.

Dadurch wird die Ausgestaltung, beziehungsweise das Design der Leiterplatte eingeschränkt.

Das Deutsche Patent- und Markenamt hat in der Prioritätsanmeldung zu vorliegender Anmeldung den folgenden Stand der Technik recherchiert: DE 296 18 489 U1.

### Aufgabenstellung

Die Aufgabe der Erfindung besteht darin ein flexibel einsetzbares elektronisches System für ein industrielles Umfeld vorzuschlagen.

Die Aufgabe wird durch den Gegenstand des unabhängigen Anspruchs 1 gelöst.

Vorteilhafte Ausgestaltungen der Erfindung sind in den Unteransprüchen und der folgenden Beschreibung angegeben.

Das erfindungsgemäße System besteht im Wesentlichen aus einem Gehäuse mit zumindest einer austauschbaren Seitenfläche. Vorzugsweise ist das Gehäuse quaderförmig, aber nicht kubisch, ausgebildet. In dem Gehäuse ist eine Leiterplatte angeordnet, die Hauptbestandteil eines nicht näher beschriebenen elektronischen Bauteils sein kann. Beispielsweise handelt es sich hierbei um ein Sensorsystem. Dann ist die Leiterplatte mit den entsprechenden Bauteilen, insbesondere Sensoren, bestückt. Weiterhin umfasst das System zumindest ein Funktionselement, welches insbesondere eine Steckschnittstelle zur Leiterplatte, bzw. zum elektronischen Bauteil bildet.

Das Funktionselement umfasst vorteilhafterweise einen Steckverbinder oder eine Steckverbinderbuchse, beispielsweise eine USB-Buchse. Das Funktionselement kann aber auch eine optische Anzeigeeinheit, beispielsweise eine LED-Anzeige, aufweisen. Die Anzeigeeinheit kann dann beispielsweise Zustände eines Systems oder eines Gerätes visualisieren.

In der zumindest einen austauschbaren Seitenfläche des Gehäuses sind Öffnungen vorgesehen, die mit elektrischen Anschlüssen der Leiterplatte korrelieren. Das bedeutet, dass durch die Öffnungen auf die elektrischen Anschlüsse der Leiterplatte zugegriffen werden kann. Das zumindest eine Funktionselement kann durch die jeweilige Öffnung der Seitenfläche in das Gehäuse eingeführt und jeweils an einen elektrischen Anschluss der Leiterplatte angeschlossen werden.

Die Leiterplatte umfasst in der Regel eine elektronische Schaltung. Oftmals umfasst die Schaltung verschiedene Sensoren, die schaltungstechnisch mit einer Steuer- und Auswerteeinheit verbunden sind. Die elektrischen Anschlüsse der Leiterplatte können auch als Schnittstelle zum elektronischen Bauteil betrachtet werden. Die Funktionselemente bilden dann insbesondere die jeweilige Steckschnittstelle zum elektronischen Bauteil. Dadurch kann das erfindungsgemäße System beispielsweise in ein übergeordnetes System, insbesondere eine Maschine oder Industrieanlage, eingebunden werden.

Vorzugsweise weist das Gehäuse zwei bis vier austauschbare Seitenflächen und zumindest zwei feste Seitenflächen auf. Bei der oben erwähnten Quaderform handelt es sich bei den zwei festen Seitenflächen um die großen Seitenflächen (Breitseiten), während die zwei bis vier austauschbaren Seitenflächen die kleineren Seitenflächen (Schmalseiten) bilden.

Die Leiterplatte hat eine rechteckige Grundform. An den Randseiten der Leiterplatte sind die elektrischen Anschlüsse für die Funktionselemente angeordnet. Die elektrischen Anschlüsse bestehen jeweils aus mehreren, auf der Leiterplatte aufgebrachten, elektrisch leitenden Kontaktplättchen, die wiederum mit Leiterbahnen der Leiterplatte elektrisch leitend verbunden sind. Die Anzahl der Kontaktplättchen entspricht in der Regel der Anzahl der Kontaktelemente der zugeordneten Funktionselemente. Die Anschlussseite der Kontaktelemente wird beispielsweise elektrisch leitend auf das jeweilige Kontaktplättchen gepresst.

Vorzugsweise weisen die Funktionselemente anschlussseitig jeweils einen axialen Schlitz auf, der den zugeordneten elektrischen Anschluss der Leiterplatte übergreift bzw. umgreift. Die Breite des axialen Schlitzes ist vorteilhafterweise etwas kleiner als die Dicke der Leiterplatte, so dass die oben erwähnte Aufpressung zwischen Anschlussseite der Kontaktelemente und Kontaktplättchen zustande kommt. Die Anschlussseite der Kontaktelemente wird auf die zugeordneten Kontaktplättchen gepresst, wodurch eine sichere, leitende Verbindung entsteht.

Es ist vorteilhaft, wenn die austauschbaren Seitenflächen jeweils eine unterschiedliche Anzahl an Öffnungen aufweisen. Die Anzahl und die Position der Öffnungen entspricht der Anzahl und der Position der elektrischen Anschlüsse der Leiterplatte, die zur jeweiligen Seitenfläche ausgerichtet sind. Je nach Seitenfläche und der Anzahl der darin befindlichen Öffnungen kann das System an verschiedene Leiterplattendesigns angepasst werden.

Das Gehäuse besteht vorzugsweise aus einem Grundgestell, dass bereits die festen Seitenflächen (Breitseite) aufweist. Die unterschiedlichen, austauschbaren Seitenflächen können, je nach Bedarf, an diesem Grundgestell befestigt werden. Die Befestigung kann beispielsweise über eine Schraubverbindung erfolgen.

In einer vorteilhaften Ausführungsform der Erfindung weist eine austauschbare Seitenfläche des Gehäuses außenseitig ein Befestigungsmittel auf, mit welchem das Gehäuse an einem Halteprofil, beispielsweise einer Hutschiene, befestigbar ist. Dadurch können beispielsweise mehrere erfindungsgemäße Systeme mit unterschiedlichen elektronischen Bauteilen auf einer Hutschiene nebeneinander aufgereiht werden.

Vorzugsweise ist in zwei gegenüberliegenden Seitenflächen jeweils eine Nut eingebracht. Die Nuten sind parallel zueinander ausgerichtet. Die Breite der jeweiligen Nuten entspricht in etwa der Dicke der Leiterplatte. In die Nuten ist die Leiterplatte einschiebbar, wodurch die Leiterplatte sicher im System gehalten ist. Die Nuten verlaufen etwa mittig in den jeweiligen Seitenflächen, so dass die Leiterplatte zu den zu ihr parallelen Seitenwänden jeweils den gleichen Abstand hat. Dadurch wird die Leiterplatte im industriellen Umfeld, insbesondere vor Vibrationen, mechanisch geschützt.

Idealerweise besteht das Gehäuse und/oder die zumindest eine Seitenfläche aus Aluminium. Ein derartiges Material ist leicht und robust. Gegenüber einem Kunststoffgehäuse ist jedoch eine ausreichende Leitfähigkeit vorhanden, so dass ggf. auch eine Erdung der Leiterplatte oder der darauf aufgebrachten Komponenten vorgenommen werden kann, sofern dies notwendig ist.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Explosionszeichnung eines erfindungsgemäßen Systems und
- Fig. 2: eine schematische Draufsicht auf eine Leiterplatte des Systems.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

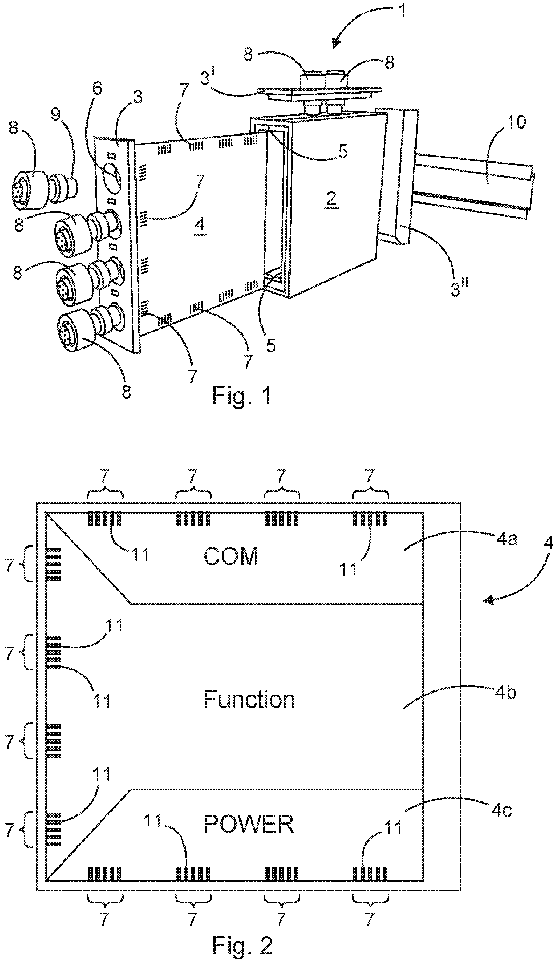

Die Figur 1 zeigt eine Explosionszeichnung eines erfindungsgemäßen Systems 1. Das hier gezeigte System 1 besteht aus einem Gehäuse 2, welches zwei feste Seitenflächen und vier austauschbare Seitenflächen 3 aufweist, wobei drei dieser austauschbaren Seitenfläche 3, 3', 3" aus darstellerischen Gründen, vom Gehäuse 2 beabstandet dargestellt sind.

In dem Gehäuse 2 ist eine Leiterplatte 4 angeordnet. Die Leiterplatte 4 wird in die, in zwei gegenüberliegenden Seitenwänden eingebrachten, Nuten 5 in das Gehäuse 2 eingeschoben und dadurch gehalten. Die austauschbaren Seitenwände 3, 3' enthalten jeweils eine unterschiedliche Anzahl an Öffnungen 6. Die Öffnungen 6 korrelieren zu den ihnen zugeordneten elektrischen Anschlüssen 7, die randseitig umlaufend auf der Leiterplatte 4 vorgesehen sind.

An die elektrischen Anschlüsse 7 werden Funktionselemente 8 angeschlossen. Die Funktionselemente 8 umfassen Kontaktelemente, die aus darstellerischen Gründen in den Figuren nicht gezeigt sind. Die Funktionselemente 8 weisen anschlussseitig jeweils einen Schlitz 9 auf. In diesen Schlitz 9 sind die jeweiligen Anschlussbereiche der Kontaktelemente positioniert. Durch Einschieben der Leiterplatte 4 in den Schlitz 9 des Funktionselements 8 werden die Anschlussbereiche der Kontaktelemente mit den Kontaktplättchen 11 der jeweiligen elektrischen Anschlüsse 7 in elektrisch leitenden Kontakt gebracht. Dadurch kann ein besonders einfacher Zusammenbau des Systems 1 erreicht werden. Die Funktionselemente 8 weisen umlaufende Dichtungen auf, die die Öffnungen bzw. das System vor Eindringen von Medien (Wasser, Staub, etc.) schützen.

Eine austauschbare Seitenfläche 3" ist außenseitig mit einem Befestigungsmittel für eine Hutschiene 10 ausgestattet. Dadurch kann das System auf einer Hutschiene 10, zusammen mit weiteren Komponenten, aufgereiht werden. Dies ist besonders bei großen Industrieanlagen oder Schaltschränken vorteilhaft.

In Figur 2 ist eine Leiterplatte 4 gezeigt, die für das erfindungsgemäße System 1 einsetzbar ist. Die Leiterplatte 4 hat eine rechteckige, in diesem Fall sogar quadratische, Grundform. Die Leiterplatte 4 ist im Wesentlichen in drei Funktionseinheiten 4a, 4b und 4c aufgeteilt. Die erste Funktionseinheit 4a stellt eine Kommunikationsschnittstelle dar. Hierüber wird ein Datenaustausch des Systems, beispielsweise zu einem übergeordneten System, realisiert. Die zweite Funktionseinheit 4b der Leiterplatte 4 enthält die wesentlichen Bestandteile des Systems 1. Hierbei handelt es sich beispielsweise um eine Sensorschaltung. Über die dritte Funktionseinheit 4c wird die Leiterplatte 4 bzw. das gesamte System 1 mit der notwendigen Energie (elektrischen Strom) versorgt.

An drei Randseiten der Leiterplatte 4 sind elektrischen Anschlüsse 7 für Funktionselemente 8 angeordnet. Die elektrischen Anschlüsse 6 bestehen jeweils aus mehreren Kontaktplättchen 11. Diese sind jeweils mit zumindest einer Leiterbahn der Leiterplatte 4 (aus darstellerischen Gründen nicht gezeigt) elektrisch leitend verbunden.

### Gehäuse für elektronische Bauteile

### Bezugszeichenliste

- 1: System
- 2: Gehäuse
- 3: Austauschbare Seitenfläche
- 4: Leiterplatte
- 5: Nut
- 6: Öffnung
- 7: Elektrischer Anschluss
- 8: Funktionselement
- 9: Schlitz
- 10: Hutschiene
- 11: Kontaktplättchen

## Patentansprüche

1. System (1) bestehend aus einem Gehäuse (2), einer in dem Gehäuse (2) angeordneten Leiterplatte (4) und zumindest einem Funktionselement (8), wobei das Gehäuse (2) zumindest eine austauschbare Seitenfläche (3, 3', 3") aufweist,
wobei in der zumindest einen austauschbaren Seitenfläche (3, 3', 3") Öffnungen (6) vorgesehen sind, die mit elektrischen Anschlüssen (7) der Leiterplatte (4) korrelieren,
wobei die Funktionselemente (8) jeweils durch eine Öffnung (7) der Seitenfläche (3, 3', 3") auf die Ihnen zugeordneten elektrischen Anschlüsse (7) der Leiterplatte (4) durchgreifen und daran angeschlossen sind,
**dadurch gekennzeichnet, dass**
die Leiterplatte (4) eine rechteckige Grundform aufweist, wobei an den Randseiten der Leiterplatte (4) die elektrischen Anschlüsse (7) für die Funktionselemente (8) angeordnet sind und dass die elektrischen Anschlüsse (7) jeweils aus mehreren Kontaktplättchen (11) bestehen, die jeweils mit zumindest einer Leiterbahn der Leiterplatte (4) elektrisch leitend verbunden sind.

2. System nach Anspruch 1
**dadurch gekennzeichnet, dass**
das Gehäuse (2) zwei bis vier austauschbare Seitenflächen (3, 3', 3") und zumindest zwei feste Seitenflächen aufweist.

3. System nach vorstehendem Anspruch
**dadurch gekennzeichnet, dass**
zumindest zwei austauschbare Seitenflächen (3, 3', 3") eine unterschiedliche Anzahl an Öffnungen (6) aufweisen.

4. System nach den beiden vorstehenden Ansprüchen
**dadurch gekennzeichnet, dass**
die festen Seitenflächen gegenüberliegend angeordnet sind.

5. System nach Anspruch 2
**dadurch gekennzeichnet, dass**
zumindest eine austauschbare Seitenfläche (3, 3', 3") des Gehäuses (2) außenseitig ein Befestigungsmittel aufweist, mit welchem das Gehäuse (2) an einer Hutschiene (10) befestigbar ist.

6. System nach einem der vorstehenden Ansprüche
**dadurch gekennzeichnet, dass**
in zwei gegenüberliegenden Seitenflächen (3, 3', 3") jeweils eine Nut (5) eingebracht ist, in welche die Leiterplatte (4) einschiebbar bzw. einsetzbar ist.

7. System nach einem der vorstehenden Ansprüche
**dadurch gekennzeichnet, dass**
die Funktionselemente (8) anschlussseitig jeweils einen axialen Schlitz (9) aufweisen, der den ihm zugeordneten elektrischen Anschluss (7) der Leiterplatte (4) übergreift.

8. System nach einem der vorstehenden Ansprüche
**dadurch gekennzeichnet, dass**
das Gehäuse (2) und/oder die zumindest eine austauschbare Seitenfläche (3, 3', 3") aus Aluminium besteht.

9. System nach einem der vorstehenden Ansprüche
**dadurch gekennzeichnet, dass**
das Gehäuse (2) quaderförmig ausgebildet ist.

## Claims

1. System (1) consisting of a housing (2), a printed circuit board (4) arranged in the housing (2) and at least one functional element (8), wherein the housing (2) has at least one changeable side (3, 3', 3"), wherein openings (6), which correlate to electrical connections (7) of the printed circuit board (4), are provided in the at least one changeable side (3, 3', 3"), wherein the functional elements (8) each extend through an opening (7) in the side (3, 3', 3") to the electrical connections (7) of the printed circuit board (4) which are associated with them and are connected to said connections, **characterized in that** the printed circuit board (4) has a rectangular basic form, wherein the electrical connections (7) for the functional elements (8) are arranged at the edges of the printed circuit board (4) and **in that** the electrical connections (7) each consist of a plurality of contact plates (11), which are each connected to at least one trace of the printed circuit board (4) in an electrically conductive manner.

2. System according to Claim 1, **characterized in that** the housing (2) has two to four changeable sides (3, 3', 3'') and at least two fixed sides.

3. System according to the preceding claim, **characterized in that** at least two changeable sides (3, 3', 3'') have a different number of openings (6).

4. System according to the two preceding claims, **characterized in that** the fixed sides are arranged opposite each other.

5. System according to Claim 2, **characterized in that** at least one changeable side (3, 3', 3") of the housing (2) has a fastening means on the outside, with which the housing (2) can be fastened to a top hat rail (10).

6. System according to one of the preceding claims, **characterized in that** a respective groove (5), into which the printed circuit board (4) can be slid or inserted, is incorporated in two opposite sides (3, 3', 3").

7. System according to one of the preceding claims, **characterized in that** the functional elements (8) have, on the connection side, a respective axial slot (9) which extends over the electrical connection (7) of the printed circuit board (4) which is associated with said slot.

8. System according to one of the preceding claims, **characterized in that** the housing (2) and/or the at least one changeable side (3, 3', 3") is made of aluminium.

9. System according to one of the preceding claims, **characterized in that** the housing (2) has a cuboidal form.

## Revendications

1. Système (1) constitué d'un boîtier (2), d'une carte de circuit imprimé (4) agencée dans le boîtier (2) et d'au moins un élément fonctionnel (8), le boîtier (2) présentant au moins une surface latérale interchangeable (3, 3', 3"),
des ouvertures (6) étant prévues dans l'au moins une surface latérale interchangeable (3, 3', 3''), lesquelles sont en corrélation avec des connexions électriques (7) de la carte de circuit imprimé (4),
les éléments fonctionnels (8) traversant respectivement une ouverture (7) de la surface latérale (3, 3', 3'') sur les connexions électriques (7) de la carte de circuit imprimé (4) qui leur sont associées et y étant raccordés,
**caractérisé en ce que**
la carte de circuit imprimé (4) présente une forme de base rectangulaire, les connexions électriques (7) pour les éléments fonctionnels (8) étant agencées sur les côtés de bord de la carte de circuit imprimé (4), et
**en ce que** les connexions électriques (7) sont constituées respectivement de plusieurs plaquettes de contact (11) qui sont respectivement reliées de manière électriquement conductrice à au moins une piste conductrice de la carte de circuit imprimé (4) .

2. Système selon la revendication 1,
**caractérisé en ce que**
le boîtier (2) présente deux à quatre surfaces latérales interchangeables (3, 3', 3'') et au moins deux surfaces latérales fixes.

3. Système selon la revendication précédente,
**caractérisé en ce**
**qu'** au moins deux surfaces latérales interchangeables (3, 3', 3'') présentent un nombre différent d'ouvertures (6).

4. Système selon les deux revendications précédentes,
**caractérisé en ce que**
les surfaces latérales fixes sont agencées en vis-à-vis.

5. Système selon la revendication 2,
**caractérisé en ce**
**qu'**au moins une surface latérale interchangeable (3, 3', 3") du boîtier (2) présente extérieurement un moyen de fixation permettant de fixer le boîtier (2) sur un profilé chapeau (10).

6. Système selon l'une quelconque des revendications précédentes,
**caractérisé en ce**
**qu'**une rainure (5) est pratiquée respectivement dans deux surfaces latérales opposées (3, 3', 3''), dans laquelle la carte de circuit imprimé (4) peut être insérée ou introduite.

7. Système selon l'une quelconque des revendications précédentes,
**caractérisé en ce que**
les éléments fonctionnels (8) présentent respectivement, du côté de la connexion, une fente axiale (9) qui recouvre la connexion électrique (7) de la carte de circuit imprimé (4) qui lui est associée.

8. Système selon l'une quelconque des revendications précédentes,
**caractérisé en ce que**
le boîtier (2) et/ou l'au moins une surface latérale interchangeable (3, 3', 3'') est constituée d'aluminium.

9. Système selon l'une quelconque des revendications précédentes,
**caractérisé en ce que**
le boîtier (2) est configuré sous forme parallélépipédique.
